# EUROPEAN PATENT APPLICATION

(11) **EP 3 761 767 A1**
(43) Date of publication of application: **06.01.2021**
(21) Application number: 20181015.7
(22) Date of filing: 19.06.2020
(51) Int. Cl.: H05K 3/36, B41J 2/14, B41J 2/16

(54) **AN INTERCONNECTION STRUCTURE CONNECTING A CHIP TO A PRINTED CIRCUIT SHEET**

(30) Priority: 02.07.2019 EP 19183923
(71) Applicant: Canon Production Printing Holding B.V., 5914 HH Venlo (NL)
(72) Inventor: KNECHTEN, Carolus A.M., 5914 CA Venlo (NL)
(74) Representative: Canon Production Printing IP Department

(57) **Abstract**

An interconnection structure (20) connecting a number of electrically conductive tracks (18) arranged side by side on a connection surface (16) on a chip (10) to a number of conductive tracks (22) on a printed circuit sheet (24), wherein the connection surface (16) and the printed circuit sheet (24) are superposed one upon the other and bonded together in a configuration in which each track (18) on the connection surface (16) makes contact with a corresponding track (22) on the circuit sheet (24), and a sealing structure (30) is provided for sealing a joint between the connection surface (16) and printed circuit sheet (24), characterized in that the sealing structure (30) comprises a barrier (32, 34) in the form of a metal strip that is formed on at least one of the connection surface (16) and the circuit sheet (24) and extends in a direction transverse to the tracks (18, 22).

## Description

The invention relates to a method of forming an interconnection structure connecting a number of electrically conductive tracks arranged side by side on a connection surface of a chip to a number of conductive tracks on a printed circuit sheet, wherein the connection surface and the printed circuit sheet are superposed one upon the other and bonded together in a configuration in which each track on the connection surface makes contact with a corresponding track on the circuit sheet, and a sealing structure is provided for sealing a joint between the connection surface and the printed circuit sheet. The sealing structure comprises a barrier in the form of a metal strip that is formed on at least one of the connection surface and the circuit sheet and extends in a direction transverse to the tracks.

More particularly, the invention relates to an ink jet printer having an interconnection structure of the type specified above. An example of such an interconnection has been disclosed in US 2006/027937 A1, US 2016/128174 A1, WO 2012/132346 A1, US 2012/068353 A1, and US 2008/170102 A1.

An ink jet printer typically has an array of narrowly spaced ejection units each of which has an electro-mechanical transducer, e.g. a piezoelectric actuator, for creating acoustic pressure waves that result in the ejection of ink droplets from nozzles of the ejection units. The print head or at least an array of ejection units of the print head may be constituted by a MEMS chip (Micro-Electro-Mechanical System) which is manufactured by means of photolithographic techniques. In order to print an image, the transducers in the MEMS chip must be controlled individually by means of an electronic controller that is connected to the chip. The interconnection structure discussed here has the purpose to connect each individual transducer to a track on the printed circuit sheet which connects the chip to the electronic controller. Typically, the printed circuit sheet is a flexible sheet, e.g. a so-called FPC (Flexible Printed Circuit).

Since an ink jet printer operates with liquid ink and the electrical connections of the interconnection structure are sensitive to moisture and ink, respectively, it is necessary to protect the electrical connections on the connection surface of the chip against the ingress of ink. To that end, the sealing structure is provided for sealing the joint between the connection surface and the printed circuit sheet.

Conventionally, the sealing structure is constituted by a synthetic resin that encapsulates the entire interconnection structure. A drawback of the known interconnection structures is that the sealing structure is relatively complex, leading to additional processing steps and thus increased costs.

It is an object of the invention to provide an interconnection structure with a more reliable and efficiently formed sealing structure.

According to the invention, forming the barrier is performed in the same step as forming the contact pad..

The permeability of the metal barrier to water and other liquids is much smaller than the permeability of known resins, so that, by using a metal barrier, the protection of the electrical connections can be improved. Moreover, the same techniques, such as screen printing or the like, that are used for forming the electrically conductive tracks on the connection surface of the chip and/or on the printed circuit sheet may also be utilized for forming the metal barrier, so that the structure according to the invention can be manufactured in a very efficient way and in a process that is integrated in the process of forming the tracks. The barrier and contact are formed in the same step, for example by simultaneous deposition of metal material through a mask. As such, adding the barrier requires no additional manufacturing steps.

More specific optional features of the invention are indicated in the dependent claims.

In an embodiment, the barrier and the contact pad are deposited on the interconnection structure in the same step, for example by sputtering, vapor phase, or e-beam deposition. Preferably, lithographic techniques are used for forming the interconnection structure. In a preferred embodiment, the barrier and the contact pad are deposited by means of a mask to determine their respective shapes, and wherein the same mask is used for depositing the barrier and the contact pads. The mask comprises openings which determine a shape, size, and/or position of the barrier and the contact pads, respectively. Preferably, the barrier and the contact pads are formed in the same step and of the same material, specifically fo the same metal.

The present invention further relates to interconnection structure as described above, wherein the contact pad and barrier are formed of the same material.

In one embodiment, the metal barrier may be formed on the connection surface of the chip, preferably in a position spaced apart from the ends of the tracks. Then, when the printed circuit sheet is bonded to the connection surface, the metal barrier comes into contact with the printed circuit sheet and will reliably seal the gap or joint between the printed circuit sheet and the connection surface. Typically, the tracks on the printed circuit sheet that lead away from the connection surface on the chip will come into contact with the metal barrier. In that case, the metal barrier may be covered with an insulating layer in order to prevent the tracks on the printed circuit sheet from being short-circuited.

In a typical print head design of an ink jet printer, the side of the connection surface where the tracks on the printed circuit sheet are led out is the side that is most exposed to moisture. In many cases it will therefore be sufficient to protect this side of the connection surface by providing the metal barrier.

Optionally, a metal barrier may also be provided on the printed circuit sheet, preferably in a position spaced apart from the ends of the conductive tracks on that sheet. This barrier will then reliably prevent the ingress of moisture at the edge of the printed circuit sheet.

Embodiment examples will now be described in conjunction with the drawings, wherein:
- Fig. 1: is a sectional view of a part of an ink jet print head having an interconnection structure according to the invention;
- Fig. 2: is an exploded sectional view of parts of a print head chip and a printed circuit sheet constituting an interconnection structure according to the invention;
- Fig. 3: is a top plan view of the chip and parts of the interconnection structure;
- Fig. 4: is a sectional view of the part of the ink jet print head of Fig. 1 shown prior to deposition of the metal barrier and contact pads; and
- Fig. 5: is a sectional view of the part shown in Fig. 4 after deposition of the metal barrier and contact pads;

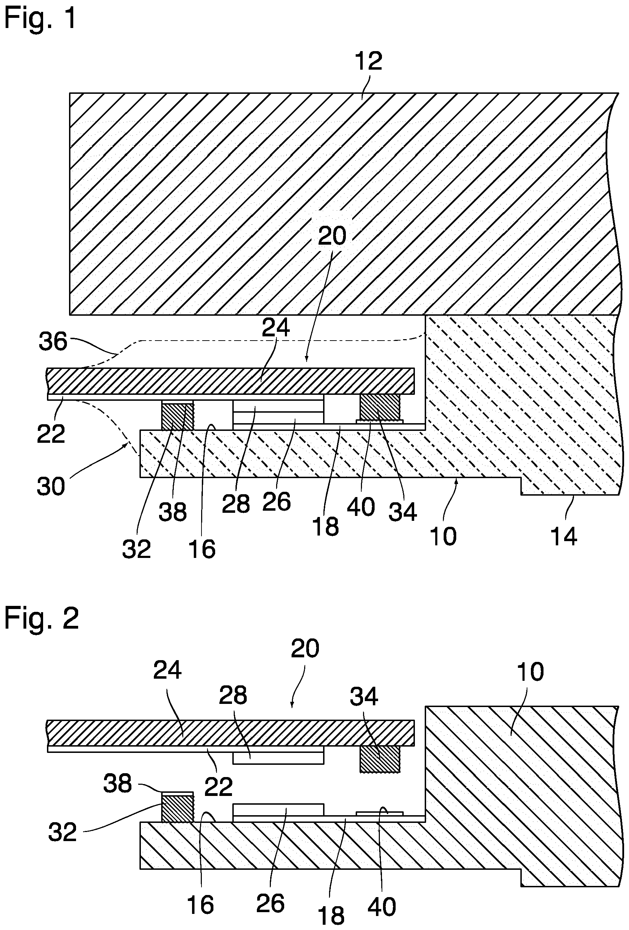

As is shown in Fig. 1, an ink jet printer has a print head in the form of a MEMS chip 10 that is mounted on a bottom side of a carrier 12. For example, the carrier 12 may be a carriage that is arranged to move across a recording medium so that the print head scans the surface of the recording medium.

The chip 10 has on its bottom side a nozzle face 14 with an array of nozzles (not visible here) that extend in the direction normal to the plane of the drawing in Fig. 1. Each nozzle is connected to an ejection unit that includes an electro-mechanical transducer that can be energized under the control of an electronic controller (not shown) in order to expel ink droplets from the nozzle.

The chip 10 has a recessed part which forms a connection surface 16 that is facing the carrier 12. A number of electrically conductive tracks 18 are led out from the main part of the chip 10 and from the transducers accommodated therein and extend over the connection surface 16 in the direction from right to left in Fig. 1. While only a single track 18 is visible in Fig. 1, a large number of tracks 18 extend in parallel to one another over the connection surface 16, each track being connected to an electrode of one of the transducers.

The tracks 18 on the connection surface 16 form part of an interconnection structure 20 by which each of the tracks 18 is electrically connected to a corresponding track 22 on a bottom surface of a flexible printed circuit sheet 24. The interconnection structure 20 has been formed by superposing the printed circuit sheet 24 on the connection surface 16 and bonding the end portion of the sheet 24 that overlaps with the connection surface 16 to this connection surface in a configuration in which each of the tracks 18 makes electrical contact with one of the tracks 22 of the printed circuit sheet. In the example shown, an end portion of each track 18 is configured as a contact pad 26 that has a larger thickness than the rest of the track. Similarly, an end portion of each of the tracks 22 of the printed circuit sheet 24 is configured as a contact pad 28 having a larger thickness than the rest of the track 22, so that the contact pads 26 and 28 are firmly held in contact with one another.

The printed circuit sheet 24 may be bonded to the contact surface 26 for example by means of an ACF-type adhesive (Anisotropic Conductive Film) which assures good electrical contact between the contact pads 26 and 28 while keeping the individual pairs of contact pads 26, 28 and the pairs of tracks 18, 22 isolated from the neighbouring pairs.

In the example shown in Fig. 1, a sealing structure 30 for preventing the ingress of moisture into the interconnection structure 20 has three components, namely a metal barrier 32 formed on the connection surface 16 of the chip 10, another metal barrier 34 formed on the bottom side of the printed circuit sheet 24, and a resin coating 36 that encapsulates the entire interconnection structure 20.

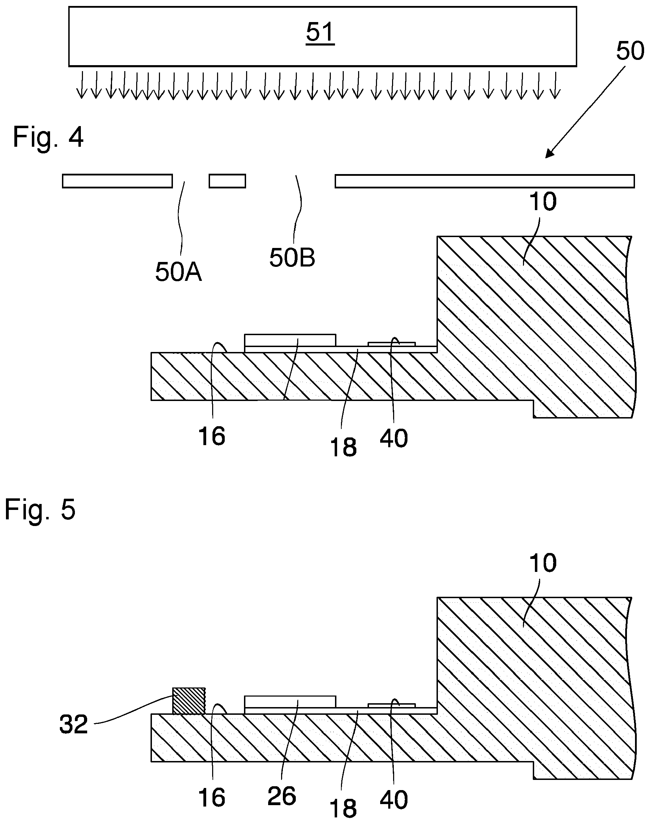

The metal barrier 32 is formed near the outboard edge of the connection surface 16 and is spaced apart from the ends of the tracks 18 and tightly seals the gap between the connection surface 16 and the bottom surface of the printed circuit sheet 24. In order to prevent the tracks 22 from being short-circuited, an insulating layer 38 is formed on the top surface of the metal barrier 32. The metal barrier 32 is formed by means of metal deposition using a mask (50 in Fig. 4) with an opening 50A at a corresponding position for the barrier 32. This mask 50 further includes one or more openings 50B defining the contact pads 32. During metal deposition, the mask 50 is positioned over the connection surface 16. Metal is deposited locally for a predetermined time. The area and position of the barrier 32 and contact pads 26 is substantially determined by the mask openings 50A, 50B, while their thickness or height may be controlled by the deposition time and/or rate. Therein, the mask 50 is positioned between the metal (vapor) source and the connection surface 16.

The other metal barrier 34 is formed near a terminal edge of the printed circuit sheet 24 so as to close the gap between the sheet 24 and the connection surface 16 on the opposite side of the contact pads 26, 28. Here, an insulating layer 40 is formed on the top surfaces of the tracks 18 in order to prevent short-circuits.

Since the side of the interconnection structure 20 that extends along the terminal edge of the printed circuit sheet 24 is much less exposed to moisture than the opposite edge, the barrier 32 is most important, and the barrier 34 may optionally be dispensed with. The resin coating 36 is also optional.

Fig. 2 shows the components of the interconnection structure 20 in an exploded view, showing more clearly that the barrier 32 is attached to the connection surface 16 whereas the barrier 34 is attached to the printed circuit sheet 24.

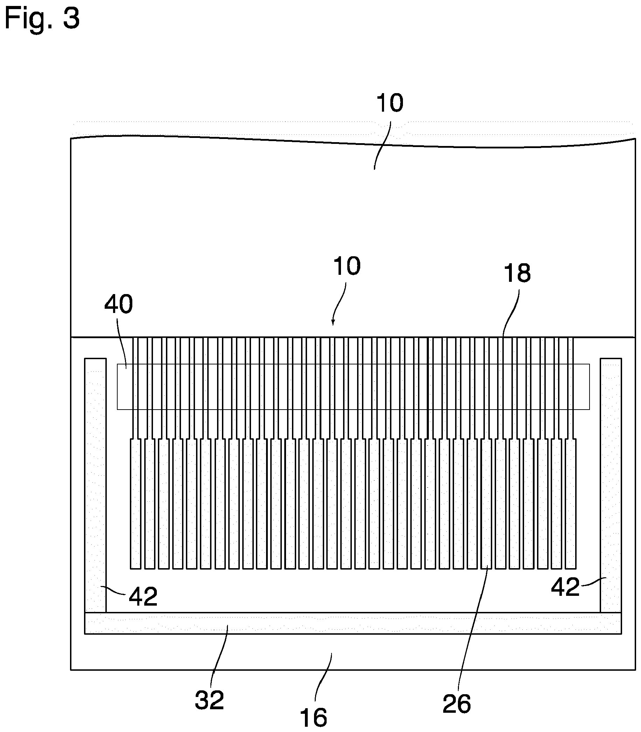

Fig. 3 is a top plan view of the part of the chip 10 that forms the chip-side parts of the interconnection structure 20. In particular, Fig. 3 shows the array of parallel tracks 18 on the connection surface 16 as well as the contact pads 26. In the example shown here, the width of the contact pads 26 is slightly larger than the width of the rest of the tracks 18. On the other hand, Fig., 3 illustrates an example in which the top surfaces of the contact pads 26 are level with the top surfaces of the tracks 18. In general, the contact pads may differ from the tracks in both, thickness and width. The same holds true for the contact pads 28 and the tracks 22 on the printed circuit sheet that is not shown in Fig. 3.

Fig. 3 also shows the metal barrier 32 extending all along the outboard edge of the connection surface 16. The insulating layer 40 extending across the tracks 18 has also been shown. Optionally, the insulating material of the layer 40 may also fill the gaps between the tracks 18, so that the top surface of the insulating layer 40 mates with the entire bottom surface of the barrier 34 (shown in Figs. 1 and 2). The same holds true for the insulating layer 38 and the tracks 22.

Fig. 3 also shows optional metal barriers 42 which extend along the lateral sides of the connection surface 16 and, together with the barriers 32 and 34, form a closed frame preventing the ingress of moisture from all sides.

## Claims

1. A method for forming an interconnection structure (20) connecting a number of electrically conductive tracks (18) arranged side by side on a connection surface (16) on a chip (10) to a number of conductive tracks (22) on a printed circuit sheet (24), wherein the connection surface (16) and the printed circuit sheet (24) are superposed one upon the other and bonded together in a configuration in which each track (18) on the connection surface (16) is provided with a contact pad (26, 28) which makes contact with a corresponding track (22) on the circuit sheet (24), and a sealing structure (30) is provided for sealing a joint between the connection surface (16) and printed circuit sheet (24), wherein the sealing structure (30) comprises a barrier (32) in the form of a metal strip that is formed on at least one of the connection surface (16) and the circuit sheet (24) and extends in a direction transverse to the tracks (18, 22), **characterized in that** forming the barrier (32) is performed in the same step as forming the contact pad (26, 28).

2. The method according to claim 1, wherein the barrier (32) and the contact pad (26, 28) are deposited on the interconnection structure (20) in the same step.

3. The method according to any of the preceding claims, wherein the barrier (32) and the contact pad (26, 28) are deposited by means of a mask to determine their respective shapes, and wherein the same mask is used for depositing the barrier (32) and the contact pads (26, 28).

4. The method according to any of the preceding claims, wherein the step of forming the barrier (32) and the contact pads (26, 28) comprising depositing material on the interconnection structure (20) through a mask, which mask comprises openings for determining a shape and/or position of the barrier (32) and the contact pads (26, 28).

5. An interconnection structure (20) connecting a number of electrically conductive tracks (18) arranged side by side on a connection surface (16) on a chip (10) to a number of conductive tracks (22) on a printed circuit sheet (24), wherein the connection surface (16) and the printed circuit sheet (24) are superposed one upon the other and bonded together in a configuration in which each track (18) on the connection surface (16) is provided with a contact pad (26, 28) which makes contact with a corresponding track (22) on the circuit sheet (24), and a sealing structure (30) is provided for sealing a joint between the connection surface (16) and printed circuit sheet (24), wherein the sealing structure (30) comprises a barrier (32) in the form of a metal strip that is formed on at least one of the connection surface (16) and the circuit sheet (24) and extends in a direction transverse to the tracks (18, 22), **characterized in that** the barrier (32) and the contact pad (26, 28) are formed from the same metal.

6. The interconnection structure according to claim 5, wherein the barrier (32) is formed on the connection surface (16).

7. The interconnection structure according to claim 6, wherein the barrier (32) is formed in an edge portion of the connection surface (16) and spaced apart from ends of the tracks (18).

8. The interconnection structure according to claim 7, wherein the barrier (32) extends across the tracks (22) on the printed circuit sheet (24) and is insulated from these tracks by an insulating layer (38).

9. The interconnection structure according to any of claims 5 to 8, wherein the sealing structure (30) comprises a further metal barrier (34) that is formed on the printed circuit sheet (24).

10. The interconnection structure according to claim 9, wherein the further metal barrier (34) is formed in an edge portion of the printed circuit sheet (24) and spaced apart from ends of the tracks (22) of that sheet.

11. The interconnection structure according to claim 10, wherein the further metal barrier (34) extends across the tracks (18) on the connection surface (16) and is insulated from these tracks by an insulating layer (40).

12. An ink jet print head formed of a chip having an interconnection structure connected to a printed circuit sheet (24) according to any of claims 5 to 11, wherein the chip comprises a nozzle face (14) with an array of nozzles for jetting droplets ink and the interconnection structure (20) is positioned facing away from the nozzle face (14) at an an edge portion of the interconnection structure (20), such that the barrier is positioned between the nozzle face (14) and the contact pad (32), when viewed circumferentially around the edge portion.

13. An ink jet printer having a chip (10) that forms at least a part of an ink jet print head according to claim12.
